Europäisches Patentamt

European Patent Office

Office européen des brevets

(19)

(11) Numéro de publication: **0 246 959 B1**

(12) **FASCICULE DE BREVET EUROPEEN**

(45) Date de publication de fascicule du brevet: **30.09.92**
(51) Int. Cl.⁵: $H01S\ 3/103$, $H01S\ 3/06$

(21) Numéro de dépôt: **87401103.4**

(22) Date de dépôt: **15.05.87**

(54) **Laser à semi-conducteur à réaction distribuée et à longueur d'onde continûment accordable.**

(30) Priorité: **16.05.86 FR 8607064**

(43) Date de publication de la demande:
**25.11.87 Bulletin 87/48**

(45) Mention de la délivrance du brevet:
**30.09.92 Bulletin 92/40**

(84) Etats contractants désignés:
**DE GB NL**

(56) Documents cités:
**EP-A- 0 169 567**
**GB-A- 2 106 706**

**PATENT ABSTRACTS OF JAPAN, vol. 7, no.
174 (E-190)[1319], 2 août 1983; & JP-A-58 78
488**

**ELECTRONICS LETTERS, vol. 20, no. 24, 22
novembre 1984, pages 1016-1018, Staines,
Middlesex, GB; H. SODA et al.: "GaInAsP/InP
phase-adjusted distributed feedback lasers
with a step-like nonuniform stripe width
structure"**

(73) Titulaire: **Bouley, Jean-Claude
35, Avenue du Docteur Durand
F-94110 Arcueil(FR)**

Titulaire: **Correc, Pascal
3, Villa d'Alésia
F-75014 Paris(FR)**

(72) Inventeur: **Bouley, Jean-Claude
35, Avenue du Docteur Durand
F-94110 Arcueil(FR)**
Inventeur: **Correc, Pascal
3, Villa d'Alésia
F-75014 Paris(FR)**

(74) Mandataire: **Mongrédien, André et al
c/o SOCIETE DE PROTECTION DES INVEN-
TIONS 25, rue de Ponthieu
F-75008 Paris(FR)**

ELECTRONICS LETTERS, vol. 20, no. 23, 8 novembre 1984, Staines, Middlesex, GB; L.D. WESTBROOK et al.: "Monolithic 1.5 mum hybrid DFB/DBR lasers with 5 nm tuning range"

PATENT ABSTRACTS OF JAPAN, vol. 9, no. 201 (E-336)[1924], 17 août 1985; & JP-A-60 66 490

ELECTRONICS LETTERS, vol. 21, no. 2, 17 janvier 1985, pages 63-65, Staines, Middlesex, GB; M. YAMAGUCHI et al.: "Wide range wavelength tuning in 1.3 mum DBR-DC-PBH-LDs by current injection into the DBR region"

## Description

La présente invention a pour objet un laser à semi-conducteur à réaction distribuée et à longueur d'onde continûment accordable.

Les progrès obtenus récemment dans le domaine des lasers à semi-conducteurs ouvrent des perspectives intéressantes pour les futurs systèmes de transmission par fibres optiques. Ainsi, grâce à la bonne monochromaticité des lasers dits à réaction distribuée ("Distributed Feedback Lasers" ou encore lasers DFB en abrégé), il est possible d'accroître considérablement la capacité des liaisons, en transmettant plusieurs longueurs d'onde sur la même fibre par multiplexage optique. On peut aussi augmenter la distance entre les répéteurs, en utilisant la technique de détection cohérente. On sait qu'il s'agit là d'une technique dans laquelle on combine sur un même détecteur, la lumière transmise par la fibre optique avec celle qui provient d'un laser de même longueur d'onde appelé "oscillateur local".

Cependant, un des problèmes cruciaux posés par ces applications, reste celui de la dispersion en longueur d'onde des lasers issus d'une même plaque de semi-conducteur ou de deux plaques différentes. Les dispersions observées aujourd'hui sur les lasers DFB sont de quelques dizaines d'Angströms (20 à 30) (1 Angström = $10^{-10}$ m.). Des opérations de tri sont donc nécessaires pour faire coïncider la longueur d'onde d'émission des sources avec celle des multiplexeurs ou démultiplexeurs optiques, ou bien pour faire coïncider la longueur d'onde de la source avec celle de l'oscillateur local, pour les systèmes cohérents.

La présente invention a pour but d'apporter une solution à ce problème en proposant un laser dont la longueur d'onde peut être accordée électroniquement sur une plage de plusieurs dizaines d'Angströms. A titre annexe, l'invention permet d'obtenir une modulation de la fréquence optique d'émission.

Pour bien comprendre l'invention, il n'est pas inutile de rappeler en quoi consiste un laser DFB, même si ces structures sont aujourd'hui bien connues.

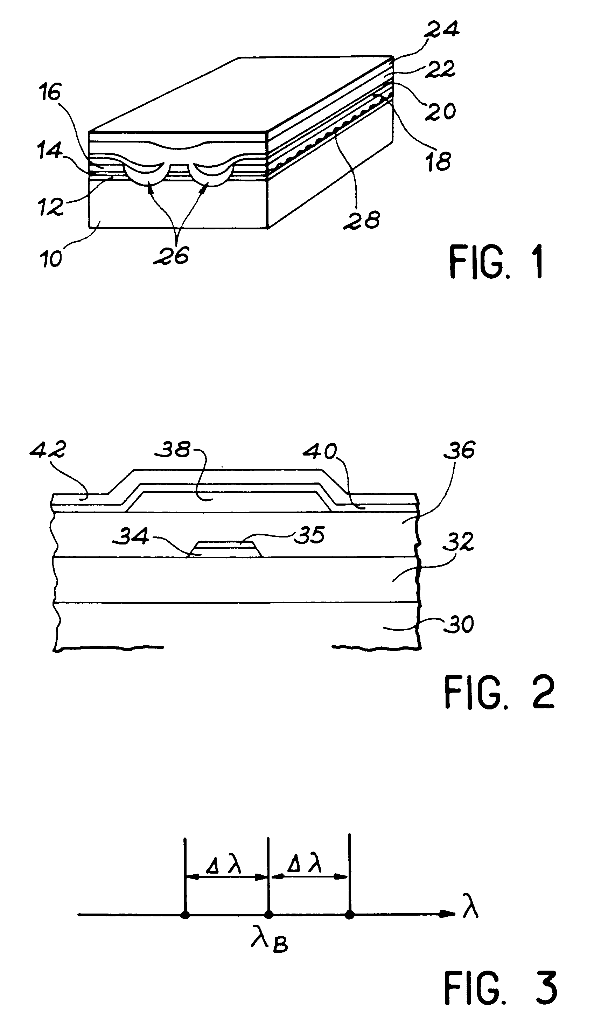

La figure 1 annexée montre une telle structure à contre-réaction distribuée dans une variante dite à ruban enterré. Il s'agit d'une réalisation japonaise de la NEC Corporation décrite dans un article intitulé : "Low threshold and high temperature single longitudinal mode operation of 1.55 $\mu$m - Band DFB-DC-PBH-LD's" par M. Kitamura et al publié dans Electronics Letters, 5 juillet 1984, 20-p. 596-597.

Cette structure comprend un substrat 10 en InP dopé n, une couche active 12 en InGaAsP, une couche de guidage 14 en InGaAsP, une couche de confinement 16 en InP dopé p, une couche 18 en InP dopé p, une couche 20 en InP dopé n, une couche 22 en InP dopé p et enfin une couche de contact 24 en InGaAsP dopé p.

La structure à contre-réaction distribuée proprement dite comprend un réseau holographique 28 du premier ou deuxième ordre (0,24 ou 0,48 $\mu$m de pas) gravé dans le guide formé par la couche 14 située juste au-dessus de la couche active 12, laquelle fonctionne à 1,55 $\mu$m de longueur d'onde. Le confinement électronique des lignes de courant dans le ruban est obtenu à l'aide des couches de type p et n, en forme de croissants 26, situées de part et d'autre de la zone active 12 du laser.

Une autre structure est connue par la publication de J.C. BOULEY et al, intitulée : "1.55 $\mu$m strip buried Schottky laser" dans "Proceedings of the 9th IEEE International Semiconductor Laser Conference", août 7-10, 1984. Cette structure est représentée sur la figure 2. Elle comprend un substrat 30 en InP dopé $n^+$ , une couche de confinement 32 en InP dopé n, un ruban d'environ 2 $\mu$m de large formé d'une couche active 34 en GaInAsP et d'une couche de guidage 35 en GaInAsP, ce ruban étant enterré dans une couche 36 en InP dopé p ; cette couche est recouverte d'une couche 38 en GaInAs en forme de mésa d'environ 5 $\mu$m de large. L'ensemble est recouvert d'une couche de titane 40 et d'or 42.

La structure DFB est obtenue en gravant un réseau holographique dans la couche 35 fonctionnant à 1,3 $\mu$m, puis en effectuant une reprise d'épitaxie en prenant soin de ne redissoudre ni le réseau ni le ruban. La longueur d'onde d'émission d'un laser DFB est trés proche de celle dite de Bragg ($\lambda_B$) fixée par le pas du réseau P et l'indice effectif n de la lumière dans la couche active du laser ($\lambda_B = 2nxP$ au deuxième ordre). En fait, la théorie et l'expérience montrent que l'oscillation laser a lieu d'un côté ou de l'autre de $\lambda_B$, aux longueurs d'onde $\lambda_B + \Delta\lambda$ ou $\lambda_B$-$\Delta\lambda$, comme le montre la figure 3, l'intervalle 2 $\Delta\lambda$ correspondant approximativement à la longueur du filtre formé par le réseau. On peut aussi montrer par le calcul et vérifier expérimentalement que l'émission se produit à $\lambda_B + \Delta\lambda$ ou $\lambda_B$-$\Delta\lambda$ suivant la position des miroirs clivés par rapport à la période du réseau. Cette indétermination est d'ailleurs une des causes principales de la dispersion en longueur d'onde mentionnée ci-dessus. Elle s'ajoute à celles qui résultent des fluctuations d'indice effectif provoquées par les hétérogénéités d'épaisseur des couches et de longueur de la partie active du laser.

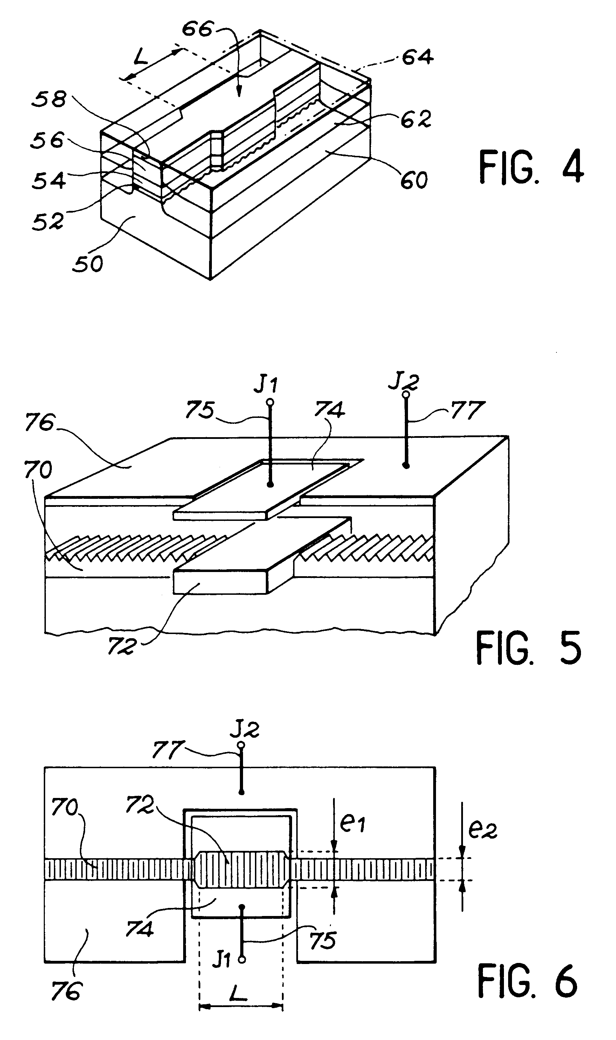

La structure DFB classique a été modifiée récemment de manière à n'obtenir une oscillation laser qu'à la longueur d'onde de Bragg. Un des exemples de ces nouvelles structures a été décrit par H. Soda et al dans la revue Electronics Letters du 22 novembre 1984, vol. 20, page 1017. Cette structure est représentée sur la figure 4. Elle comprend un substrat 50 en InP de type n, une couche de guidage 52 en GaInAsP de type n, cette couche étant gravée en réseau, une couche active 54 en GaInAsP, une couche 56 en InP de type p, une couche de contact 58 en GaInAsP, une couche 60 en InP enterrant la couche active, une couche 62 en InP de type n, et enfin une électrode 64 recouvrant le tout.

Le ruban constitué par la couche active, la couche de guidage et la couche de confinement comprend une partie centrale 66 élargie par rapport au reste du ruban. La longueur de cette partie élargie est L.

La vitesse de propagation de l'onde lumineuse dans le ruban dépend de l'indice effectif n, lequel se trouve modifié d'une quantité $\Delta n$ par l'élargissement du ruban. Dans la partie élargie, on montre que l'onde directe et l'onde diffractée par le réseau se trouvent déphasées l'une par rapport à l'autre d'une quantité $\Delta\beta$ égale à $2\pi/\lambda_B.\Delta n$. Sur la totalité de la section de longueur L, le déphasage est égal à $\Delta\beta$xL.

Dans la structure de H. Soda et al, la longueur L est choisie pour que ce déphasage soit égal à $\frac{\pi}{2}$. H. Soda et al ont obtenu ces conditions pour un élargissement du ruban de 2 à 3 $\mu$m et une longueur L égale à 60 $\mu$m.

D'autres structures ont été aussi proposées pour obtenir le même résultat, dans lesquelles au lieu d'élargir le ruban sur une distance L c'est l'épaisseur des guides qui est modifiée sur une distance équivalente, comme décrit par F. Koyama et al dans Electronics Letters, 10 mai 1984, vol. 20, n° 10, p. 391. On peut aussi créer un déphasage spatial de $\frac{\lambda}{4}$ (à l'ordre 2) entre les traits du réseau en un point sensiblement centré au milieu de la cavité comme décrit par K. Sekartedjo et al dans Electronics Letters, 19 janvier 1984, vol. 20, n° 2, p. 80.

Si ces lasers représentent un progrès en ce sens qu'ils permettent d'obtenir une longueur d'onde calée sur la longueur d'onde de Bragg, ils présentent encore des dispersions du fait des hétérogénéités qui subsistent inévitablement dans la structure. Par ailleurs, ces lasers ne sont évidemment pas réglables en longueur d'onde, celle-ci étant fixée par construction. Ils conviennent donc encore assez mal aux systèmes nécessitant une grande précision de longueur d'onde.

La présente invention a pour objet une structure DFB dans laquelle une commande électronique continue de la longueur d'onde d'émission est possible et ce, sur une plage pouvant atteindre plusieurs dizaines d'Angströms (30 à 50). Les inconvénients de l'art antérieur sont donc surmontés.

Ce résultat est obtenu en séparant l'électrode d'injection des charges en deux électrodes, une première placée au-dessus de la zone centrale élargie ou épaissie et une seconde sur le reste du ruban. De cette manière, le courant injecté dans la zone centrale élargie est indépendant de celui qui est injecté dans le reste de la structure. Il peut donc être réglé à volonté pour ajuster le déphasage à une valeur souhaitée, et donner à la longueur d'onde une valeur quelconque située entre $\lambda_B$-$\Delta\lambda$ et $\lambda_B + \Delta\lambda$.

Patent Abstracts of Japan, vol.7, no.174 (E-190)[1319], 2 août 1983, & JP-A-5 878 488, décrit un laser à semiconducteur à reaction distribuée comprenant deux électrodes latérales et une électrode centrale. Le courant injecté dans la zone centrale est réglé de manière que la différence de phase soit égale à $\pi/2$.

De toute façon, l'invention sera mieux comprise à la lumière de la description qui suit. Cette description se réfère à des dessins annexés sur lesquels :
- la figure 1, déjà décrite, représente une structure à réaction distribuée à ruban enterré,
- la figure 2, déjà décrite, représente une autre structure de ce type,
- la figure 3, déjà décrite, est un diagramme montrant la plage d'oscillation d'un laser à réaction distribuée,
- la figure 4, déjà décrite, montre une structure de l'art antérieur comprenant un ruban à zone centrale élargie,
- la figure 5 montre schématiquement une structure selon l'invention,
- la figure 6 montre schématiquement, en vue de dessus, une structure selon l'invention,
- la figure 7 est un schéma électrique équivalent montrant l'injection de charges dans le laser de l'invention,
- la figure 8 est un diagramme montrant les variations de la puissance optique émise en fonction de la densité de courant injecté, pour différentes valeurs du courant injecté dans la partie centrale,
- la figure 9 montre un laser complet selon l'invention,
- la figure 10 montre un premier masque permettant de réaliser la partie centrale élargie,
- la figure 11 montre un second masque permettant de graver les électrodes.

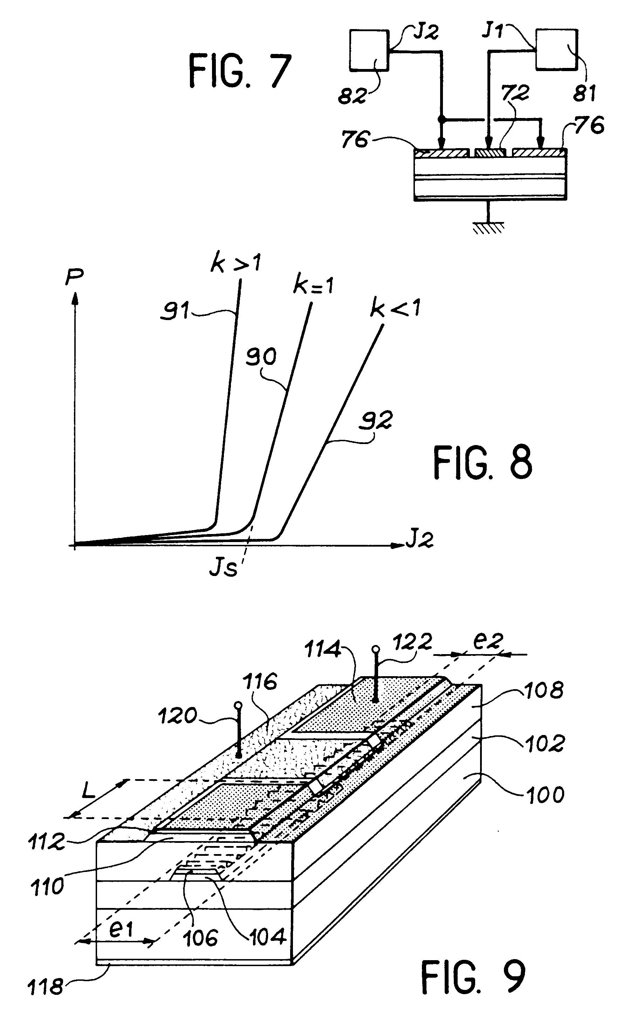

La structure représentée sur la figure 5 est schématique en ce sens que les différentes couches active, de confinement ou de contact, n'ont pas été représentées explicitement. Seule la couche de guidage 70 est représentée avec sa partie centrale élargie 72 qui sert de section de déphasage. La structure complète sera illustrée sur la figure 9. L'originalité du laser de la figure 5 tient dans la partition de l'électrode supérieure en une partie centrale 74 reliée à une connexion 75 véhiculant un courant $J_1$ et une partie 76, entourant la partie centrale 74, et reliée à une connexion 77 véhiculant un courant $J_2$.

La même structure vue de dessus est représentée sur la figure 6.

On observera que la partie centrale élargie 72, qui introduit le déphasage, est gravée en réseau de diffraction comme le reste du ruban.

L'invention peut aussi s'appliquer à la structure de F.KOYAMA et al. décrite ci-dessus ; une des électrodes sera alors placée au-dessus de la zone centrale possédant un guide plus épais, l'autre électrode recouvrant le reste du ruban.

Le fonctionnement de cette structure est le suivant. Dans la zone centrale, l'indice effectif a la valeur $n_0$ et dans le reste du ruban gravé la valeur $n_1$. Si L est la longueur de la zone centrale un déphasage $\beta$ est obtenu qui a pour valeur $(n_0-n_1) \cdot L.2\pi/\lambda$. Trois cas peuvent se produire :

a)- lorsqu'on augmente la valeur du courant $J_1$ injecté dans le déphaseur correspondant à la zone centrale, l'indice effectif $n_0$ diminue de la quantité $\Delta n_0$ égale à $-(\partial n_a/\partial N)x\Gamma x\Delta N$ où $\partial n_a/\partial N$ est la loi de variation connue de l'indice de réfraction de la couche active avec le nombre de porteurs injectés, $\Gamma$ le facteur de confinement optique et $\Delta N$ le nombre de porteurs injectés dans la zone active (en première approximation, $\Delta N$ peut se calculer par l'expression $\Delta N = \Delta J_1/\sqrt{2J_1.qdB}$, où q est la charge de l'électron, B la probabilité de recombinaison, d l'épaisseur de la région active). Ainsi, le déphasage peut tendre vers 0 et la longueur d'onde d'émission du laser se déplacer vers $\lambda_B + \Delta\lambda$. De plus, compte tenu de l'excès de gain induit dans le déphaseur, il est évident que le courant $J_2$ à injecter dans le reste de la structure diminue.

b)- Inversement, une diminution du courant $J_1$ entraîne une augmentation de l'indice effectif du déphaseur et donc, selon la relation donnée plus haut, un accroîssement du déphasage. Un calcul simple avec les relations ci-dessus montre que le déphasage peut tendre vers $\pi$ et que, par conséquent, la longueur d'onde peut être déplacée jusqu'à $\lambda_B-\Delta\lambda$. La diminution de gain dans le déphaseur va, en revanche, induire une augmentation du courant de seuil.

c)- Si le courant $J_1$ est égal au courant $J_2$, on retrouve une injection uniforme dans l'ensemble de la structure et, par conséquent, la situation que l'on a dans l'art antérieur avec la structure décrite par H. Soda et al. Le déphasage est alors égal à $\frac{\pi}{2}$ (car la longueur L est choisie pour que le déphasage ait cette valeur dans le cas d'une injection homogène). La longueur d'onde d'émission est alors égale à la longueur de Bragg $\lambda_B$.

La figure 7 montre le schéma électrique équivalent du laser de l'invention avec deux générateurs de courant 81 et 82 délivrant deux courants $J_1$ et $J_2$.

Le diagramme de la figure 8 montre les variations de la puissance lumineuse P émise par le laser en fonction de la densité de courant $J_2$ injecté dans le ruban, la densité de courant $J_1$ injectée dans la zone centrale de déphasage étant prise comme paramètre. Si l'on désigne par $J_s$ la densité de courant de seuil correspondant à une injection uniforme, on peut noter $J_1 = kJ_s$. On a alors trois cas différents :

- si $k=1$, on a $J_1 = J_s$ et l'émission a lieu à $\lambda_B$; c'est la courbe 90 du diagramme de la figure 8,
- si $k>1$, la longueur d'onde peut être accordée jusqu'à $\lambda_B + \Delta\lambda$ suivant la valeur de k ; on obtient la courbe 91,
- si $k<1$, la longueur d'onde peut être accordée jusqu'à $\lambda_B-\Delta\lambda$; on obtient la courbe 92.

Le calcul et l'expérience montrent que les variations de courant $J_1$ nécessaires pour observer l'accord sont de quelques milliampères (environ 5) pour un laser à ruban enterré présentant un courant de seuil $J_s$ d'une vingtaine de milliampères.

La plage d'accord en longueur d'onde est ainsi égale à 2 $\Delta\lambda$, c'est-à-dire à la largeur de la bande caractéristique du réseau (bande appelée "stop-band"). La meilleure valeur publiée pour cette bande est de 39 Angströms. Une optimisation des paramètres technologiques du réseau (ordre, forme...) permet d'obtenir un accord de 50 à 60 Angströms.

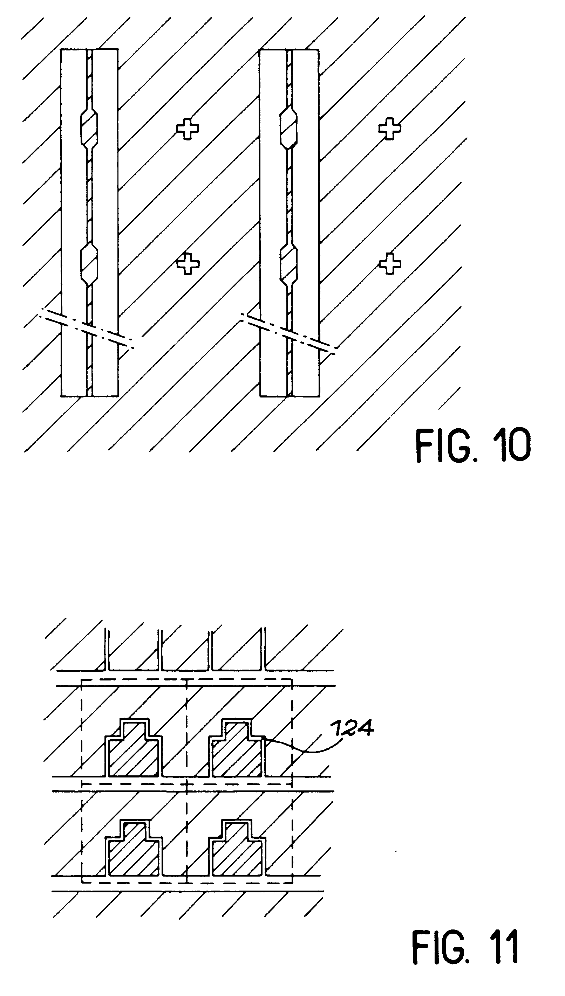

Un exemple de procédé de réalisation de la structure de l'invention va maintenant être décrit. La figure 9 montre le laser obtenu par ce procédé et les figures 10 et 11 deux masques mis en oeuvre dans ce procédé.

Le procédé pris comme exemple comprend schématiquement six étapes :

1 - Formation d''une hétérostructure par épitaxie en phase liquide ou épitaxie en phase vapeur OM-CVD ; cette hétérostructure comprend, sur un substrat 100 de type $n^+$:

- une couche 102 d'InP de type n dopée entre $510^{17}$ et $10^{17}$ électrons/cm$^3$,
- une couche active 104 en GaInAsP de longueur d'onde 1,55 $\mu$m ou 1,3 $\mu$m suivant la longueur d'onde souhaitée pour le laser,
- une couche guide 106 en GaInAsP 1,3 $\mu$m pour un laser 1,5 $\mu$m ou 1,15 $\mu$m pour un laser 1,3 $\mu$m.

2 - Gravure dans la couche 106 d'un réseau du premier ou deuxième ordre par les techniques de masquage et de gravure classique (masquage holographique ou masquage électronique).

3 - Gravure chimique ou ionique du réseau pour lui donner une forme de ruban selon le motif représenté figure 10. Les dimensions critiques sont $e_0$, $e_1$ et L. On peut prendre par exemple $e_0 = 2\mu m$, $e_1 = 3\mu m$ et L = 50$\mu m$. Les valeurs optimales se situent entre 1 et 3$\mu m$ pour $e_1$, 2-4$\mu m$ pour $e_2$ et 20-100$\mu m$ pour L, pour un laser de longueur comprise entre 200 et 400$\mu m$.

4 - Reprise d'épitaxie pour former une couche 108 d'InP de type p et une couche 110 d'InGaAsP de type p$^+$. La technique de croissance la mieux appropriée pour cette étape est l'épitaxie en phase vapeur aux organométalliques car les motifs gravés avec le masque de la figure 10 : ruban, déphaseur, croix de centrage, réapparaissent en surface après reprise, ce qui facilite d'autant le réalignement des contacts.

5 - Prise de contact : après les opérations usuelles d'amincisement du substrat 100, des contacts Au-Ge (118) et Au-Zn (112) sont déposés sur toute la surface respectivement sur les côtés n et p de la structure. Le contact 112 est ensuite gravé en forme de ruban de 4 $\mu m$ de large à l'aplomb du ruban enterré puis interrompu au niveau de la zone centrale à l'aide du masque représenté figure 11. Ce masque présente une fente 124 qui sépare les deux électrodes. Dans ce masquage la longueur L doit être identique à celle du déphaseur de la figure 10. On obtient alors une électrode 114 et une électrode 116 séparées l'une de l'autre.

6 - Métallisation Ti-Au : afin de faciliter la prise de contact sur le ruban 112 en Au-Zn de 4 $\mu m$ de large, on procède tout d'abord à la gravure de la couche de contact 110 de part et d'autre du ruban 112 en Au-Zn, puis on dépose un contact 114 en Ti-Au sur le ruban Au-Zn et sur la couche 108 d'InP-p ainsi dégagée. Il est connu que le contact Ti-Au ainsi réalisé permet un confinement du courant injecté dans le ruban (cf. la demande de brevet français FR-A-2 488 049) car il forme un contact ohmique au centre et deux barrières Schottky sur les bords, au contact avec InP de type p.

La structure finale est obtenue après clivage et montage de la puce laser, puis soudure de deux fils 120 et 122 sur les deux électrodes 116 et 114 déposées côté p.

Pour finir, il faut observer que l'idée de contrôler électroniquement la longueur d'onde d'émission d'un laser DFB a déjà été émise par plusieurs auteurs. On peut citer par exemple l'article de M. Kitamura et al dans IEEE, JQE, N° 21, mai 1985, pages 415-417. Dans une telle structure la phase de l'onde lumineuse par rapport au réseau est reliée par un modulateur de phase intra-cavité appelé "tuning region". Selon le courant injecté dans cette zone, on peut obtenir une émission stable à $\lambda_B + \Delta\lambda$ où à $\lambda_B - \Delta\lambda$ et l'on s'affranchit ainsi de l'indétermination sur $\lambda$ résultant du clivage de la cavité. Le modulateur de phase est tout simplement constitué par la structure laser démunie de son réseau. Le passage du courant dans cette région change l'indice de propagation proportionnellement au nombre de porteurs injectés, ce qui permet de régler la distance optique qui sépare la face clivée et le réseau.

Une structure analogue peut être utilisée avec une région sans réseau qui est utilisée pour l'amplification optique et une avec réseau qui sert à accorder l'indice effectif. Cette structure permet d'obtenir une variation discontinue de longueur d'onde sur une plage de 40 Angströms, avec une variation par pas de 5 Angströms. Il s'agit en fait d'une structure légèrement différente de la diode à réaction distribuée, dite structure DBR (pour "Distributed Bragg Reflector") où la sélectivité en longueur d'onde et l'accord sont obtenus en distribuant la contre-réaction du réseau à l'extérieur de la cavité.

Une telle structure est décrite par exemple dans l'article de M. Yamagushi et al publié dans Electronics Letters du 17 janvier 1985, vol. 21, n° 2, pages 64-65.

La structure de l'invention se distingue de ces dispositifs par le fait que l'injection de charges se fait dans une zone située à l'intérieur de la cavité, dans une partie élargie ou épaissie qui produit en elle-même un déphasage d'origine géométrique, ce déphasage étant ajusté électroniquement. De cette manière, l'accord en longueur d'onde est continu et non pas discontinu comme dans l'art antérieur, ce qui constitue un avantage décisif pour les liaisons optiques.

EP-A-0 169 567 décrit un laser à semiconducteur à réaction distribuée qui permet d'obtenir un accord continu en longueur d'onde. Ce laser comprend une région laser avec réseau de diffraction et une région de modulation de phase sans réseau de diffraction, les deux régions ayant des électrodes indépendantes. La face réfléchissante de la région de modulation de phase a un coefficient de réflexion à 50% ou plus et la variation du courant injecté dans cette région permet d'obtenir un accord continu en longueur d'onde.

## Revendications

**1.** Laser à semi-conducteur à réaction distribuée comprenant un substrat (100) et, sur ce substrat, une double hétérostructure constituée par une couche de confinement (102), une couche active (104), une couche de guidage (106) gravée pour constituer un réseau de diffraction, cette couche active (104) et cette couche de guidage (106) étant gravées pour former un ruban ayant des extrémités (70) présentant une certaine largeur ($e_2$) et une certaine épaisseur et une partie centrale (72) de largeur ($e_1$) ou d'épaisseur plus grande, une électrode métallique surmontant l'ensemble et permettant l'injection de charges à travers le ruban, ce laser étant caractérisé par le fait que l'électrode métallique comprend deux parties distinctes formant une première électrode (74, 116) placée au-dessus de la partie centrale (72) élargie ($e_2$) ou épaissie au ruban, cette première électrode (72, 116) étant reliée à une première connexion (75, 120) pour l'injection d'un premier courant ($J_1$) et une seconde électrode (76, 114) placée au-dessus des extrémités (70) du ruban et reliée à une seconde connexion (77, 122) pour l'injection d'un second courant ($J_2$).

**2.** Laser selon la revendication 1, caractérisé par le fait que le ruban est enterré dans une première couche épitaxiée (108), une seconde couche épitaxiée (110) en forme de mésa surmontant la première couche épitaxiée (108).

**3.** Laser selon la revendication 2, caractérisé par le fait qu'une première couche métallique (112) surmonte la mésa.

**4.** Laser selon la revendication 3, caractérisé par le fait que la première et la seconde électrodes (116, 114) sont constituées par une seconde couche métallique recouvrant la première couche épitaxiée (108) et la première couche métallique (112), un contact ohmique étant formé entre la première et la seconde couches métalliques et un contact Schottky étant formé entre la seconde couche métallique et la première couche épitaxiée (108).

## Claims

**1.** Distributed feedback semiconductor laser comprising a substrate (100) and, on the said substrate, a double heterostructure constituted by a confinement layer (102), an active layer (104), a guidance layer (106) etched in order to form a diffraction network, whereby said active layer (104) and said guidance layer (106) are etched to form a ribbon having ends (70) with a certain width ($e_2$) and a certain thickness and a central part (72) of width ($e_1$) or greater thickness, a metal electrode surmounting the assembly and permitting the injection of charges through the said ribbon, said laser being characterized in that the metal electrode has two separate parts forming a first electrode (74, 116) placed above the thickened or widened ($e_2$) central part (72) of the ribbon, said first electrode (72, 116) being connected to a first connection (75, 120) for the injection of a first current ($J_1$) and a second electrode (76, 114) placed above the ends (70) of the ribbon and connected to said second connection (77, 122) for the injection of a second current ($J_2$).

**2.** Laser according to claim 1, characterized in that the ribbon is buried in a first epitaxied layer (108), a second epitaxied layer (110) shaped like a mesa surmounting the first epitaxied layer (108).

**3.** Laser according to claim 2, characterized in that a first metal layer (112) surmounts the mesa.

**4.** Laser according to claim 3, characterized in that the first and second electrodes (116, 114) are constituted by a second metal layer covering the first epitaxied layer (108) and the first metal layer (112), an ohmic contact being formed between the first and second metal layers and a Schottky contact being formed between the second metal layer and the first epitaxied layer (108).

## Patentansprüche

**1.** Halbleiterlaser mit verteilter Rückkopplung, bestehend aus einem Substrat (100) und, auf diesem Substrat, einer doppelten Heterostruktur, bestehend aus einer Einschließungsschicht (102), einer aktiven Schicht (104), einer Führungsschicht (106), die derart geätzt ist, daß sie ein Beugungsgitter darstellt, wobei diese aktive Schicht (104) und diese Führungsschicht (106) derart geätzt sind, daß sie einen Streifen mit Enden (70) einer gewissen Breite ($e_2$) und einer gewissen Dicke und einen Mittelteil (72) einer größeren Breite ($e_1$) oder Dikke darstellen, und einer Metallelektrode über der Gesamtanordnung, die eine Ladungsträgerinjektion durch den Streifen ermöglicht, Laser, dadurch gekennzeichnet, daß die Metallelektrode aus zwei verschiedenen Teilen besteht, die eine erste über dem verbreiterten ($e_2$) oder verdickten Mittelteil (72) des Streifens angeordnete Elektrode (74, 116) darstellen, die zur Injektion eines ersten Stromes ($J_1$) mit einem ersten Anschluß (75, 120) verbunden ist, und eine zweite über den Enden (70) des Streifens angeordnete Elektrode (76, 114), die zur Injektion eines zweiten Stromes ($J_2$) mit

einem zweiten Anschluß (77, 122) verbunden ist.

2. Laser gemäß Patentanspruch 1, dadurch gekennzeichnet, daß der Streifen in einer ersten epitaktisch aufgewachsenen Schicht (108) begraben wird, wobei eine zweite mesaförmige epitaktisch aufgewachsene Schicht (110) über der ersten aufgewachsenen Schicht (108) liegt.

3. Laser gemäß Patentanspruch 2, dadurch gekennzeichnet, daß eine erste Metallschicht (112) über der Mesa liegt.

4. Laser gemäß Patentanspruch 3, dadurch gekennzeichnet, daß die erste und die zweite Elektrode (116, 114) aus einer zweiten Metallschicht bestehen, die die erste epitaktisch aufgewachsene Schicht (108) und die erste Metallschicht (112) überdeckt, wobei ein ohmscher Kontakt zwischen der ersten und der zweiten Metallschicht und ein Schottky-Kontakt zwischen der zweiten Metallschicht und der ersten aufgewachsenen Schicht (108) ausgebildet ist.

FIG. 1

FIG. 2

FIG. 3

FIG. 4

FIG. 5

FIG. 6

FIG. 7

FIG. 8

FIG. 9

FIG. 10

124

FIG. 11